# EUROPEAN PATENT SPECIFICATION

(11) **EP 3 021 354 B1**
(45) Date of publication and mention of the grant of the patent: **24.06.2020**
(21) Application number: 14306808.8
(22) Date of filing: 14.11.2014
(51) Int. Cl.: F04B 19/24, F04B 19/00, H01L 23/473

(54) **A fluidic pump**
Fluidische Pumpe
Pompe fluidique

(43) Date of publication of application: 18.05.2016
(73) Proprietor: Alcatel Lucent, 91620 Nozay (FR)
(72) Inventor: Jeffers, Nicholas, Dublin, Blanchardstown (IE); Stafford, Jason, Dublin, Blanchardstown (IE); Donnelly, Brian, Dublin, Blanchardstown (IE); Nolan, Kevin, Dublin, Blanchardstown (IE)
(74) Representative: Browne, Robin Forsythe

(56) References cited:
- WO-A1-2005/071748
- US-A- 2 910 836
- US-A1- 2006 078 434
- US-A1- 2011 020 140

## Description

The present disclosure relates to cooling techniques for electronic or optical equipment using fluidic pumps.

### BACKGROUND

The recent significant growth in data traffic in telecommunications requires more functionality from future electronic or photonics packages. More functionality implies comparatively higher levels of heat generation. The current thermal solutions employed today do not appear to be capable of scaling sufficiently to meet future network demands. One approach for cooling such components is based on using fluidic pumps. WO 2005/071748 A1 describes a cooling system for an electronic device (1) comprising a first (3), second (13) and third (2) chamber and a heater placed in the first chamber. The first and second chambers are separated by a membrane. The first chamber has also two valves (7) and (10) for directing the fluid between the third, first and second chambers. By heating the fluid in the first chamber the membrane pumps the liquid from the second chamber toward the third chamber. US 2006/078434A1 discloses a thermal actuation pump comprising a first, second chambers and a thermoelectric element arranged between the first and second chambers.

US 2910836 A describes a fluid heating and cooling apparatus using a thermoelectric element. US 2011/020140 A1 discloses a micro pump comprising a pump chamber including inflow and outflow passages and corresponding two valves through which a drive fluid flows and a pump chamber heating and cooling unit.

### SUMMARY

The present invention relates to an apparatus and a system according to the wording of claims 1 and 15 respectively. Further aspects and details of the invention are set out in the dependent claims.

### BRIEF DESCRIPTION OF THE DRAWINGS

Figures 1A, 1B and 1C are various exemplary schematic representations corresponding to a pump according to some embodiments.
Figure 2A and 2B are exemplary schematic representations corresponding to a pump according to some embodiments.
Figure 3 is an exemplary schematic representation corresponding to a pump according to some embodiments.
Figure 4 is an exemplary schematic representation corresponding to a pump according to some embodiments.

### DETAILED DESCRIPTION

Due to an increasing trend in designing small-size and highly reliable devices, a cooling mechanism used in such devices is also desired to be small and highly reliable. It is further desired that such cooling mechanism is capable of being situated within a package of reduced size and of delivering the required pressure rise in the working fluid (e.g. in the range of 10kPa or higher at a flow rate in the range of 5ml/min or higher).

Various known cooling techniques rely on the use of moving parts to cause a fluid (liquid or gas) to flow in the vicinity of the component to be cooled to thereby absorb heat from the component through thermal contact and transfer it to other environments (e.g. the ambient). Such solutions however are typically not sufficiently reliable because the moving parts will typically suffer from mechanical failure (e.g. wearing out or breakage) after some usage.

Furthermore, the pumping mechanisms using moving parts (e.g. piezoelectric diaphragm pumps) occupy some space which is typically relatively large as compared to the overall size of the device. This makes the miniaturization of the device difficult.

Some known devices such as electro-osmotic pumps have no moving parts, however these devices typically do not have the required fluidic performance and therefore are typically not suitable for applications such as micro-fluidic cooling.

The solution proposed herein takes advantage of the fact that under an increase in temperature due to absorption of heat, the volume of a fluid increases for a fixed pressure. Conversely, the pressure of the fluid increases if the volume in which it is contained is fixed.

This pressure increase may, in some cases, be the result of imposing a phase change in the fluid (e.g. liquid turning into vapor); and in some other cases, it may simply be the result of the thermal expansion in a fluid in response to an increase in temperature.

Therefore, when a fluid is heated within in a volume that is provided with an outlet, the increase in the pressure of the fluid within that volume causes the fluid to move (flow) out of that volume through its outlet.

Embodiments of the disclosure aim at harnessing the above-described effect of fluid motion induced by the pressure changes in the fluid, due to variation in temperature, to obtain a pumping effect. This pumping effect can be provided in any suitable manner. Two non-limiting examples of preferred approaches are provided below and described in further details with reference to the drawings.

A first approach is to cause the fluid to move in two opposing direction (e.g. backwards and forwards, as in a shuttle) over the components to be cooled.

A second approach relates providing a flow of the fluid on only one direction over the component to be cooled. This second approach can be achieved for example by using one-directional valves to make a pump mechanism with continuous flow in one direction.

In the context of the present description the term "thermal contact" and derivations thereof are to be understood to refer to both a direct contact, without an interface, between two elements that are meant to transfer heat between each other; an a contact through an interface (a third element) located between the two elements and capable of transferring heat from one of the two elements to the other.

In the following, some exemplary embodiments are provided in relation to micro-fluidic pumps. These pumps typically use micro-channels for the flow of fluid within the cooling mechanism. Micro-fluidic pumps may be used in applications where small size components need to be cooled, such as for example in telecommunications. Herein, a micro-channel is to be understood to refer to a channel having at least one cross sectional dimension below 1mm in length. For example a rectangular micro-channel cross section can have the following dimensions: 0.9mm x 5mm.

However the disclosure is not limited to the use of micro-channels in pumps and is likewise applicable to larger pumping applications where a reliable pump is required, for example in larger scale pumps for XFP cooling or for biomedical application where channel may have a cross-sectional dimension over 1mm.

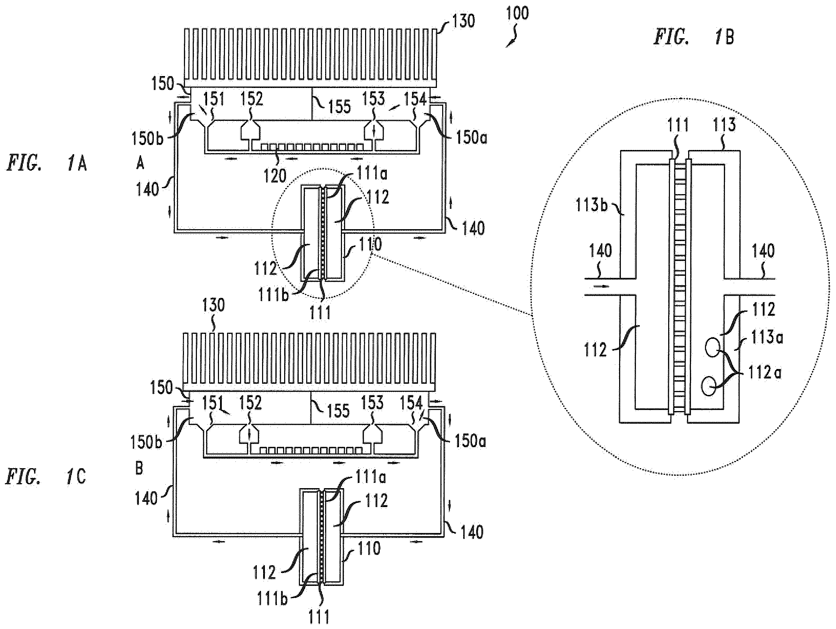

Figures 1A, 1B and 1C illustrate an example embodiment of a heat transfer assembly comprising a micro-fluidic pump according to the first approach. In these figures, by way of illustration and not limitation, a pump mechanism is shown that uses the concept of phase change (e.g. liquid-vapor). However, those skilled in the related art will understand that pump mechanism without phase change, and merely using the expansion/contraction effect of a fluid in response to variation in temperature, may also be made using the principles of the disclosure.

Referring first to figure 1A, there is shown a heat transfer assembly 100, comprising a pump 110 (in this example being a multi-phase pump), a heat source 120 which may comprise one of more optical component or one or more electronic components, to be cooled and a thermal energy removal mechanism 130 such as a heat sink.

A working fluid 112 is used for heat transfer operations. The working fluid 112 is capable of flowing through micro-channels 140 in backward or forward directions. The heat transfer assembly 100 further comprises a cooling chamber 150 through which the working fluid can flow.

The pump 110 comprises a thermoelectric cooler (TEC) 111. A TEC is a known solid-state heat pump that is capable of pumping the heat from one side to the other in response to a supplied voltage. The direction of pumping the heat depends on the polarity of the supplied voltage. If the voltage applied to the TEC is reversed, the direction of the heat pumping effect will be reversed also. Therefore, under ambient temperature, this heat transfer therefore results in one side of the TEC being above and the other side being below the ambient temperature.

Figure 1B shows the pump 110 of figure 1A in a larger scale. The pump 110 has a housing 113 comprising a first chamber 113a and a second chamber 113b. With simultaneous reference to both figures 1A and 1B, it is assumed that the TEC 111 is excited by a voltage applied thereto. As a result, one side 111a of the TEC heats up while the other side 111b cools down relative to the initial temperature within the TEC (e.g. ambient temperature). Therefore, the hot side 111a of the TEC causes the working fluid 112 to change phase from liquid to vapor 112a, thereby increasing in pressure within the boundaries 113 of the first chamber 113a. The opposing side 111b of the TEC cools the fluid, resulting in the fluid changing phase from vapor to liquid, or simply contracting in volume, thus decreasing the pressure inside the second chamber 113b. This operation causes the fluid to be shuttled in a first direction (anticlockwise in the example shown in figures 1A and 1B). As a result the fluid can move through the micro-channels 140 and enter the cooling chamber 150 (figure 1A). The cooling chamber 150 is in thermal contact with the thermal energy removal mechanism 130 through which it exchanges heat with the ambient. Therefore, the fluid 112 may be cooled down to some degree in the cooling chamber before it flows further to reach the heat source 120. Further details related to the movement of the fluid within the heat chamber are provided below.

After the fluid 112 has entered in thermal contact with the heat source 120 and absorbed heat therefrom, the heated fluid 112 then continues to flow out of the cooling chamber 150 and through micro-channels 140 to finally reach the second chamber 113b and the cooler side 111b of the TEC 111. In this manner a closed loop is provided in which the fluid is made to move, i.e. pumped, from the pump 110 toward the heat source 120 and back to the pump 110, as shown by arrows in figure 1A.

Referring now to figure 1C a scenario is shown in which the polarity of the voltage applied to the TEC 111 is reversed thereby causing the fluid 112 to move in the reverse direction (clockwise in the example shown in figure 1C) due to the same effects as described with reference to figure 1A.

The polarity of the applied voltage may be varied according to any desired frequency to meet the cooling demands of each particular application and to suit the performance of the heat transfer assembly of figures 1A, 1B and 1C.

As an additional measure to ensure efficient cooling the heat source 120 may be situated such that the fluid 112 heated by the TEC 111 does not directly reach it. For example the heat source 120 may be located at a distance from the pump which is longer than the distance along which the pump can push the fluid from the TEC 111. Therefore, with each stroke (back and forth), the fluid heated by the TEC 111 moves away from the TEC without reaching the heat source 120.

The pump may be configured such that relatively little amount of energy would be required to cause a phase transformation or thermal expansion in the fluid and thus relatively little heating is caused. For example, if the working fluid is water at atmospheric pressure, and if the system is set to operate at 99C then the TEC only needs to heat the water by 1C to trigger the phase change from a liquid to a gas; which is very little heating. On the other hand, if the pressure is reduced by applying a vacuum on the system then the phase transition temperature can be changed from 100C to another, say 50C, and the process can be repeated. In this manner the pump can be configured so that the TEC 111 does very little sensible heating of the fluid. Other fluids, for example dielectric fluids, may also be used in a similar manner.

The cooling chamber 150 comprises nozzles and diffusers 151-154. These nozzles and diffused are employed to prevent re-entrainment of the heated fluid 112 into the cooling chamber 150 after it has been heated by entering into thermal contact with the heat source 120.

In the context of the present disclosure, a nozzle may be considered to be a contraction in the cross sectional area of the micro-channel relative to the direction of flow of the fluid. Likewise, a diffuser may be considered as an expansion in the cross sectional area of the micro-channel relative to the direction of flow of the fluid. Therefore, by changing the direction of flow of the fluid, a nozzle may become a diffuser and *vice-versa.*

For example in figure 1A, elements shown by reference numerals 154 and 152 are nozzles; and elements shown by reference numerals 151 and 153 are diffusers. Diffusers have a lower resistance to fluid flow than nozzles of comparable size; therefore the fluid will tend to pass through a diffuser easier than through a nozzle.

The cooling chamber 150 comprises two sections 150a and 150b separated by a wall 155. As can be seen in the figures 1A and 1C, a nozzle 152 and a diffuser 151 are located in one section 150b of the cooling chamber and a nozzle 154 and a diffuser 153 are located in the other section 150a.

In the example of figure in figure 1A, the fluid is shown to be moving away from the right hand side of the TEC 111. It enters the right hand side section 150a of the cooling chamber and flows through the diffuser 153 and on towards the heat source 120 where it receives thermal energy. Then the fluid flows into the left hand side section 150b of the cooling chamber and finally flows toward the TEC 111 by passing through the diffuser 151 and out of the left hand section 150b of the cooling chamber. When the polarity of the voltage applied to the TEC 111 is reversed, the direction of the flow of the fluid 112 reverses (figure 1C) and therefore elements 152 and 154 (that were nozzles in the previous cases) become diffusers because of the change in the direction of the flow.

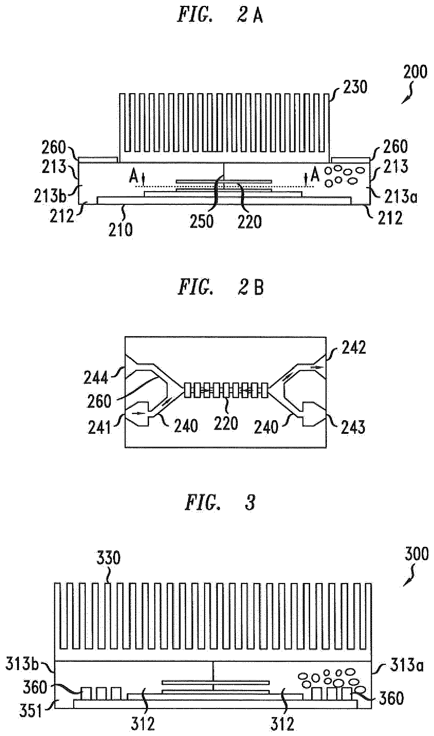

Another embodiment of the disclosure, according to the first approach, is provided with reference to figures 2A and 2B.

Figure 2A is an exemplary schematic representation of a heat transfer assembly 200 comprising a pump 210 (in this example being a multi-phase pump), a heat source 220 such as an optical or electronic component to be cooled and a thermal energy removal mechanism 230 such as a heat sink.

A working fluid 212 is used for heat transfer operations. The working fluid 212 is provided inside a housing 213. The housing 213 comprises a first chamber 213a and a second chamber 213b. The two chambers 213a and 213b are separated by a wall 250 and connected to each other by the micro-channels 240 (figure 2B).

The fluid 212 is capable of flowing through micro-channels 240 (figure 2B) in backward or forward directions between the first chamber 213a and the second chamber 213b.

The heat transfer assembly further comprises heater elements 260 provided at predetermined locations relative to the first chamber 213a and the second chamber 213b so as to be able to transfer heat, upon activation, to the working fluid in the first chamber or in the second chamber respectively. The heater elements 260 may be external to the body of the housing 213 (as shown in figure 2A), or they may be located inside the housing 213 in each of the first chamber and the second chamber. The heater elements may be chosen from any known components suitable for the application, such as for example a resistive element. In the embodiments of figure 2A, the heat source 220, e.g. electronic or photonic component, may be submerged inside the working fluid. In such a case, the working fluid is preferably a dielectric material such as hydrofluoroether.

As shown in figure 2B, the micro-channels define a path for the flow of the fluid provided adjacent (e.g. below or above) the heat source 220. The working fluid 212 is capable of flowing through the micro-channels 240 in both directions.

In operation, a first heater 260 e.g. inside the first chamber 213a is activated for example by applying electricity to a resistive element. As a result the the heater element 260 generates heat which is transferred to the fluid (either directly when the heater element is inside the housing or through the body of the housing 213 when the heater element is located outside the housing). Such heat transfer to the fluid causes the working fluid to heat up. In case a multi-phase pump is used, the heat causes the working fluid 212 to change phase locally, thereby pushing the bulk fluid from the first chamber 213a, through the micro-channels 240 into the second chamber 213b. Preferably only one heater is activated at any given time. As the fluid 212 moves from one chamber to the other, it makes thermal contact with the heat source 220 thereby absorbing heat from the latter. Subsequently, the fluid exits from the micro-channel 240 and enters into the opposing chamber. Heat is removed from this heated fluid while it is in the opposite chamber.

A reverse operation is performed in a similar fashion. For example referring back to figure 2A, upon activating the heater element 260 on the left-hand side of the figure- which was previously off - and turning off the heater element 260 on the right-hand side - which was previously on -, the direction of flow will change and the fluid will then flow from the second chamber 213b to the first chamber 213a. Preferably a valve system may be set up on the entrance and exit to the micro-channels to ensure that heated fluid does not return to the heat source to be cooled. Figure 2B illustrates a cross-sectional view, along the line A-A in figure 2A, of an area in which the heat source 220 and the micro-channels 240 are located.

As can be seen from the example shown in figure 2B, according to one direction of flow (e.g. left to right as shown by arrows in the figure) the fluid can flow from chamber 213b (figure 2A) into the micro-channel through diffuser 241, enter into thermal contact with the heat source 220, flow though a micro-channel that terminates in diffuser 242 and finally exit from the diffuser 242 to enter into the opposing chamber 213a.

In a reverse operation, upon changing the direction of flow, the fluid can flow from chamber 213a (figure 2A) into the micro-channel through diffuser 243, enter into thermal contact with the heat source 220, flow though a micro-channel that terminates in diffuser 244 and finally exit from the diffuser 244 to enter into the opposing chamber 213b.

Here again when the direction of is reversed a nozzle becomes a diffuser and *vice-versa.*

The special arrangement of the nozzles and diffusers not only ensures that the fluid is directed through the desired channels and heated fluid is not returned to the heat source, but it also ensures that the heated fluid is entered into the new chamber at a position which is at certain distance from the position where cooled fluid is going to flow back toward the heat source. For example in a left to right direction of flow in figure 2B the fluid flows out of diffuser 242 which is at a certain distance from the nozzle 243 (according to that direction of flow). When the direction of flow is reversed the now diffuser (previously nozzle) 243 allows the passage of fluid which is in proximity to the entrance of this diffuser and the heated fluid entered in the chamber 213a in proximity of the now nozzle (previously diffuser) 242 is prevented from entering the micro-channel 240. Furthermore, as the nozzle 242 is at certain distance from the diffuser 243, heated fluid in proximity of the nozzle 242 is also at certain distance from diffuser and would not enter into the diffuser 243. A repeated reversal of the direction of flow causes the heated fluid in chamber 252 to circulate within the chamber where it exchanges heat with the thermal energy removal mechanism 230 and cools off before it is returned back to the micro-channel, this time through diffuser 243.

Figure 3 is an exemplary schematic representation of a heat transfer assembly comprising a pump according to another embodiment of the disclosure.

The heat transfer assembly 300 of figure 3 is in many aspects similar to that of figures 2A and 2B, and therefore a detailed description of its structure and components is considered not necessary. However the heat transfer assembly of figure 3 is different from the embodiment of figures 2A and 2b in that instead of heater elements (or TECs), use is made of electronic or optical components which generate heat during their operation and this generated heat is used to cause the fluid to move in a back and forth direction.

In operation, a first component or group of components 360, e.g. components inside the first chamber 313a, is activated thereby generating heat. The heat generated is transferred to the fluid 312, thereby causing the bulk fluid from the first chamber 313a to move through micro-channels (not explicitly shown) into the opposing chamber 313b. This reverse operation may be made by activating the components 360 within the second chamber 313b to cause the bulk fluid from the second chamber 313b to move through micro-channels into the opposing chamber 313a. This operation may be repeated in the two direction to remove heat from the heat source to be cooled.

A valve system similar to the one described with reference to figure 2B may be set up in the apparatus of figure 3 to obtain similar effects.

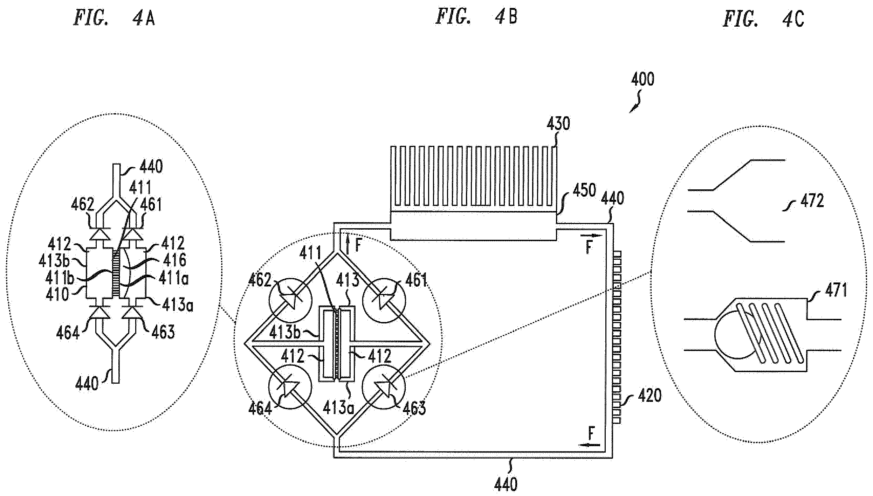

Figures 4A, 4B and 4C show different representations of a heat transfer assembly comprising a pump according to a further embodiment of the disclosure. The embodiment implements the second approach as referred to above.

The principle of operation of the heat transfer assembly of this embodiment is based on the use of one way valves to convert the periodical (back and forth) operation of the pump into a continuous one-directional flow. This principle of operation may be better understood by simulating it to an electrical AC-DC bridge rectifier as shown in figure 4B and described below.

Referring simultaneously to figures 4A and 4B an exemplary schematic representation of a heat transfer assembly 400 is shown comprising a pump 410 a heat source 420 such as an optical or electronic component to be cooled and a thermal energy removal mechanism 430 such as a heat sink.

The pump 410 comprises a housing 413. The housing 413 has a first chamber 413a and a second chamber 413b.

A working fluid 412 is used for heat transfer operations. The working fluid 412 is provided inside the first chamber 413a and the second chamber 413b of the housing and is capable of flowing from one chamber to the other through micro-channels 440.

Although in the figure the heat source 420 is shown to be adjacent to the micro-channel 440 and not submerged into the working fluid, the disclosure is not so limited and some embodiments may provide for submerging the heat source 420 inside a region where the working fluid flows, for example inside the cooling chamber 450.

The heat transfer assembly 400 further comprises a TEC 411 provided within the pump 410. The TEC 411 may be similar to the TEC described with reference to figures 1A, 1B and 1C. A cooling chamber 450 may also be provided to enhance heat transfer from the working fluid to the thermal energy removal mechanism 430.

A plurality of directional valves, 461-464, are provided to provide a one-directional flow path as will be described below.

In operation, when a voltage is applied to the TEC 411, one side 411a of the TEC heats up thereby increasing the pressure inside the boundaries of the chamber 413a where the fluid 412 is contained.

In some embodiments, as shown in figure 4A, the pump is multi-phase therefore the heating of the one side of the TEC may generate vapor in the form of a bubble 416. In this case the formation and growth of a bubble 416 may be compared to a diaphragm which can extend into the above-mentioned boundaries, e.g. the right hand side of the pump in figure 4A, thereby pushing the fluid out of the first chamber 413a.

In some embodiments the pump is not multi-phase therefore the heating of the one side of the TEC may simply cause thermal expansion in the fluid which is sufficient to push the fluid out of the first chamber 413a.

Referring back to figures 4A and 4B, when e.g. side 411a of the TEC 411 is heated, fluid is made to move out of the pump 410 from outlets of the first chamber 413a (right hand side in the figures). At the same time, side 411b of the TEC 411 is cooled causing the fluid to move into the pump 410 from inlets of the second chamber 413b (left hand side in the figures).

However while the one-directional valve 461 allows the fluid to flow out of the first chamber 413a, the valve 463 blocks the flow of the fluid in the opposite direction. Therefore the fluid flows in one direction from out of valve 461 (e.g. upward in the figures).

As the voltage applied to the TEC 411 is reversed, the opposite side 441b of the TEC is heated up and therefore the fluid is made to move out of the pump 410 from outlets of second chamber 413b (left hand side in the figures). At the same time, side 411a of the TEC 411 is cooled causing the fluid to move into the pump 410 from inlets of the first chamber 413a (right hand side in the figures). However while the one-directional valve 462 allows the fluid to flow out of the second chamber 413b, the valve 464 blocks the flow of the fluid in the opposite direction. Therefore the fluid flows in one direction out of valve 462 (e.g. upward in the figures).

Therefore, for either one of the voltage polarities applied to the TEC 411, the fluid is made to move in one direction out of the pump which is shown by arrows F in figure 4B.

It is to be noted that when chamber 413a contains hot fluid, it is pressurized thus pushing fluid out (as mentioned above). This effect will also push the one-directional valve 463 to remain closed. At the same time chamber 413b is cooled down and therefore has a reduced pressure therein. This effect will open the one-directional valve 464 and pull the fluid into the chamber 413b.

As shown in figure 4C, the directional, or one-way, valves may be active valves 471 (e.g. known check valves with moving parts) or passive valves 472 (e.g. nozzles/diffusers that have no moving parts). Active valves have greater fluidic performance however they have reliability concerns due to said moving part; while passive valves have poorer fluidic performance however they have higher reliability. The choice of the valves may therefore be made in accordance to the practical requirements of each application.

Active valves may also be used in the previous embodiments of figures 1A, 1B, 1C, 2A, 2B and 3 instead of nuzzles and diffusers.

The fluid 412 may be cooled down in the cooling chamber 450 before it flows further to reach the heat source 420.

As can be appreciated from the foregoing, the present disclosure therefore offers important advantages over the known solutions as it enables small scale, reliable in-package fluidic networks. This is due to the fact that the pumping mechanism is typically one of the main concerns in designing a device as it requires high reliability which is not easy to achieve using known solutions.

In addition to reliability, another unique benefit of the pump as proposed herein is that it can be made of any suitable shape and size and therefore is not limited to any specific footprint. Furthermore, since there are no moving parts in the proposed pump, it can be easily built on a small scale.

Further it is to be noted that the list of structures corresponding to the claimed means is not exhaustive and that one skilled in the art understands that equivalent structures can be substituted for the recited structure without departing from the scope of the invention.

It should be appreciated by those skilled in the art that any block diagrams herein represent conceptual views of illustrative circuitry embodying the principles of the invention.

## Claims

1. An apparatus (100, 200, 300, 400) comprising:
- a first heat source (111, 260, 360, 411);
- a fluid (112, 212, 312, 412);
- a first chamber (113a, 213a, 313a, 413a) and a second chamber (113b, 213b, 313b, 413b) connected to one another through a channel (140, 240, 440);
wherein the first heat source (111, 260, 360, 411) is configured to heat the fluid (112, 212, 312, 412) in the first chamber (113a, 213a, 313a, 413a) to cause the fluid (112, 212, 312, 412) to flow, through the channel, from the first chamber to the second chamber and to make thermal contact with a second heat source to absorb heat from the second heat source (120, 220, 420).

2. The apparatus (100, 200, 300, 400) of claim 1, wherein the fluid is configured to flow in a first direction in response to receiving heat in the first chamber and to flow in a second direction in response to receiving heat in the second chamber.

3. The apparatus (100, 200, 300, 400) of claim 1, wherein the fluid is configured to flow in a first direction in response to receiving heat in the first chamber and to flow in the same first direction in response to receiving heat in the second chamber.

4. The apparatus (100, 200, 300, 400) of any one of claims 1 to 3, wherein the fluid is configured to change phase from liquid to gas in response to receiving heat from the first heat source.

5. The apparatus (100, 200, 300, 400) of any one of claims 1 to 3, wherein the fluid is configured to undergo thermal expansion in response to receiving heat from the first heat source.

6. The apparatus (100, 200, 300, 400) of any one of the preceding claims, wherein the apparatus further comprises a nozzle (152, 154) and a diffuser (151, 153) located on a flow path of the fluid wherein a nozzle (152, 154) is configured to provide higher resistance to the flow of the fluid than a diffuser.

7. The apparatus (100, 200, 300, 400) of any one of the preceding claims, wherein the first heat source is configured to heat the fluid in the first chamber and cool the fluid in the second chamber.

8. The apparatus (100, 200, 300, 400) of any one of the preceding claims, wherein the first heat source is a thermoelectric cooler.

9. The apparatus (100, 200, 300, 400) of claim 8, wherein the first heat source is located between the first chamber and the second chamber.

10. The apparatus (100, 200, 300, 400) of any one of the preceding claims 1 to 7, wherein the first heat source is a located outside the first chamber and the apparatus comprises a third heat source located outside the second chamber, the third heat source being configured to heat the fluid in the second chamber.

11. The apparatus (100, 200, 300, 400) of any one of the preceding claims 1 to 7, wherein the first heat source is a located inside the first chamber and the apparatus comprises a third heat source located inside the second chamber, the third heat source being configured to heat the fluid in the second chamber.

12. The apparatus (100, 200, 300, 400) of claim 11, wherein the first heat source and the third heat source each comprise one or more electronic or optical components configured to generate heat during operation.

13. The apparatus (100, 200, 300, 400) of any one of the preceding claims, further comprising a cooling chamber configured to cool the fluid prior to the fluid reaching the second heat source.

14. The apparatus (100, 200, 300, 400) of any one of the preceding claims further comprising a plurality of one-directional valves (461, 462, 463, 464) being arranged so as to allow a flow of the fluid in one direction and to block a flow of the fluid in a direction opposite to the one direction.

15. A heat transfer assembly comprising the apparatus of any one of the previous claims 1 to 14 and further comprising a thermal energy removal mechanism (130, 230, 330, 430).

## Patentansprüche

1. Vorrichtung (100, 200, 300, 400) umfassend:
- eine erste Wärmequelle (111, 260, 360, 411);
- ein Fluid (112, 212, 312, 412);
- eine erste Kammer (113a, 213a, 313a, 413a) und eine zweite Kammer (113b, 213b, 313b, 413b), die durch einen Kanal miteinander verbunden sind;
wobei die erste Wärmequelle (111, 260, 360, 411) konfiguriert ist, um das Fluid (112, 212, 312, 412) in der ersten Kammer (113a, 213a, 313a, 413a) zu erwärmen, um zu bewirken, dass das Fluid (112, 212, 312, 412) durch den Kanal, von der ersten Kammer zur zweiten Kammer fliesst und um thermischen Kontakt mit einer zweiten Wärmequelle herzustellen, um Wärme von der zweiten Wärmequelle (120, 220, 420) zu absorbieren.

2. Vorrichtung (100, 200, 300, 400) nach Anspruch 1, wobei das Fluid konfiguriert ist, um in Reaktion auf das Aufnehmen von Wärme in der ersten Kammer in eine erste Richtung zu fliessen und in Reaktion auf das Aufnehmen von Wärme in der zweiten Kammer in eine zweite Richtung zu fliessen.

3. Vorrichtung (100, 200, 300, 400) nach Anspruch 1, wobei das Fluid konfiguriert ist, um in Reaktion auf das Aufnehmen von Wärme in der ersten Kammer in eine erste Richtung zu fliessen und in Reaktion auf das Aufnehmen von Wärme in der zweiten Kammer in dieselbe erste Richtung zu fliessen.

4. Vorrichtung (100, 200, 300, 400) nach einem der Ansprüche 1 bis 3, wobei das Fluid konfiguriert ist, um in Reaktion auf das Aufnehmen von Wärme aus der ersten Wärmequelle die Phase, von Flüssigkeit zu Gas, zu wechseln.

5. Vorrichtung (100, 200, 300, 400) nach einem der Ansprüche 1 bis 3, wobei das Fluid konfiguriert ist, um in Reaktion auf das Aufnehmen von Wärme aus der ersten Wärmequelle eine Wärmeausdehnung zu erfahren.

6. Vorrichtung (100, 200, 300, 400) nach einem der vorhergehenden Ansprüche, wobei die Vorrichtung ferner eine Düse (152, 154) und einen Diffusor (151, 153) umfasst, die auf einem Strömungsweg des Fluids angeordnet sind, wobei eine Düse (152, 154) konfiguriert ist, um der Fluidströmung einen höheren Widerstand entgegenzusetzten als ein Diffusor.

7. Vorrichtung (100, 200, 300, 400) nach einem der vorhergehenden Ansprüche, wobei die erste Wärmequelle konfiguriert ist, um das Fluid in der ersten Kammer zu erwärmen und das Fluid in der zweiten Kammer zu kühlen.

8. Vorrichtung (100, 200, 300, 400) nach einem der vorhergehenden Ansprüche, wobei die erste Wärmequelle ein thermoelektrischer Kühler ist.

9. Vorrichtung (100, 200, 300, 400) nach Anspruch 8, wobei die erste Wärmequelle zwischen der ersten Kammer und der zweiten Kammer angeordnet ist.

10. Vorrichtung (100, 200, 300, 400) nach einem der vorhergehenden Ansprüche 1 bis 7, wobei die erste Wärmequelle ausserhalb der ersten Kammer angeordnete ist und die Vorrichtung eine dritte Wärmequelle aufweist, die ausserhalb der zweiten Kammer angeordnet ist, wobei die dritte Wärmequelle konfiguriert ist, um das Fluid in der zweiten Kammer zu erwärmen.

11. Vorrichtung (100, 200, 300, 400) nach einem der vorhergehenden Ansprüche 1 bis 7, wobei die erste Wärmequelle innerhalb der ersten Kammer angeordnet ist und die Vorrichtung eine in der zweiten Kammer angeordnete dritte Wärmequelle umfasst, wobei die dritte Wärmequelle konfiguriert ist, um das Fluid in der zweiten Kammer zu erwärmen.

12. Vorrichtung (100, 200, 300, 400) nach Anspruch 11, wobei die erste Wärmequelle und die dritte Wärmequelle jeweils eine oder mehrere elektronische oder optische Komponenten umfassen, die konfiguriert sind, um während des Betriebs Wärme zu erzeugen.

13. Vorrichtung (100, 200, 300, 400) nach einem der vorhergehenden Ansprüche, wobei diese ferner eine Kühlkammer aufweist, die konfiguriert ist, um das Fluid zu kühlen, bevor das Fluid die zweite Wärmequelle erreicht.

14. Vorrichtung (100, 200, 300, 400) nach einem der vorhergehenden Ansprüche, wobei diese ferner eine Vielzahl von Einwegventilen (461, 462, 463, 464) umfasst, die so angeordnet sind, um einen Durchfluss des Fluids in eine Richtung zu ermöglichen und einen Durchfluss des Fluids in eine zu der einen Richtung entgegengesetzten Richtung zu blockieren.

15. Wärmeübertragungsanordung, umfassend die Vorrichtung nach einem der vorhergehenden Ansprüche 1 bis 14 und ferner umfassend einen Mechanismus 8130, 230, 330, 430) zum Abführen von thermischer Energie.

## Revendications

1. Équipement (100, 200, 300, 400) comprenant :
une première source de chaleur (111, 260, 360, 411) ;
un fluide (112, 212, 312, 412) ;
une première chambre (113a, 213a, 313a, 413a) et une deuxième chambre (113b, 213b, 313b, 413b) connectée l'une à l'autre via un canal (140, 240, 440) ;
selon lequel la première source de chaleur (111, 260, 360, 411) est configurée pour chauffer le fluide (112, 212, 312, 412) dans la première chambre (113a, 213a, 313a, 413a) afin de faire affluer le fluide (112, 212, 312, 412), à travers le canal, depuis la première chambre dans la deuxième chambre et afin d'établir un contact thermique avec une deuxième source de chaleur pour absorber de la chaleur de la deuxième source de chaleur (120, 220, 420) .

2. Équipement (100, 200, 300, 400) selon la revendication 1, selon lequel le fluide est configuré pour affluer dans une première direction en réponse à la réception de chaleur dans la première chambre et pour affluer dans une deuxième direction en réponse à la réception de chaleur dans la deuxième chambre.

3. Équipement (100, 200, 300, 400) selon la revendication 1, selon lequel le fluide est configuré pour affluer dans une première direction en réponse à la réception de chaleur dans la première chambre et pour affluer dans la même première direction en réponse à la réception de chaleur dans la deuxième chambre.

4. Équipement (100, 200, 300, 400) selon l'une quelconque des revendications 1 à 3, selon lequel le fluide est configuré pour changer de phase d'un liquide vers un gaz en réponse à la réception de chaleur en provenance de la première source de chaleur.

5. Équipement (100, 200, 300, 400) selon l'une quelconque des revendications 1 à 3, selon lequel le fluide est configuré pour effectuer une expansion thermique en réponse à la réception de chaleur en provenance de la première source de chaleur.

6. Équipement (100, 200, 300, 400) selon l'une quelconque des revendications précédentes, selon lequel l'équipement comprend en outre une buse (152, 154) et un diffuseur (151, 153) situés dans un chemin de flux du fluide selon lequel une buse (152, 154) est configurée pour fournir une résistance supérieure au flux du fluide qu'un diffuseur.

7. Équipement (100, 200, 300, 400) selon l'une quelconque des revendications précédentes, selon lequel la première source de chaleur est configurée pour chauffer le fluide dans la première chambre et refroidir le fluide dans la deuxième chambre.

8. Équipement (100, 200, 300, 400) selon l'une quelconque des revendications précédentes, selon lequel la première source de chaleur est un refroidisseur thermoélectrique.

9. Équipement (100, 200, 300, 400) selon la revendication 8, selon lequel la première source de chaleur est située entre la première chambre et la deuxième chambre.

10. Équipement (100, 200, 300, 400) selon l'une quelconque des revendications précédentes 1 à 7, selon lequel la première source de chaleur est située en dehors de la première chambre et l'équipement comprend une troisième source de chaleur située en dehors de la deuxième chambre, la troisième source de chaleur étant configurée pour chauffer le fluide dans la deuxième chambre.

11. Équipement (100, 200, 300, 400) selon l'une quelconque des revendications précédentes 1 à 7, selon lequel la première source de chaleur est située dans la première chambre et l'équipement comprend une troisième source de chaleur située dans la deuxième chambre, la troisième source de chaleur étant configurée pour chauffer le fluide dans la deuxième chambre.

12. Équipement (100, 200, 300, 400) selon la revendication 11, selon lequel la première source de chaleur et la troisième source de chaleur comprennent chacune un ou plusieurs composants électroniques ou optiques configurés pour générer de la chaleur pendant son fonctionnement.

13. Équipement (100, 200, 300, 400) selon l'une quelconque des revendications précédentes, comprenant en outre une chambre de refroidissement configurée pour refroidir le fluide avant que ce dernier n'atteigne la deuxième source de chaleur.

14. Équipement (100, 200, 300, 400) selon l'une quelconque des revendications précédentes, comprenant en outre une pluralité de clapets unidirectionnels (461, 462, 463, 464) disposées de manière à permettre au fluide d'affluer dans une direction et à bloquer le flux du fluide dans une direction opposée à la première direction.

15. Ensemble de transfert de chaleur comprenant l'équipement selon l'une quelconque des revendications précédentes 1 à 14 et comprenant en outre un mécanisme d'enlèvement d'énergie thermique (130, 230, 330, 430).
